# EUROPÄISCHE PATENTSCHRIFT

(11) **EP 0 347 704 B1**
(45) Veröffentlichungstag und Bekanntmachung des Hinweises auf die Patenterteilung: **15.12.1993**
(21) Anmeldenummer: 89110605.6
(22) Anmeldetag: 12.06.1989
(51) Int. Cl.: H01L 31/02, H01L 23/043, G08B 13/18

(54) **Infrarotdetektor**
Infrared detector
Détecteur infrarouge

(30) Priorität: 23.06.1988 DE 8808109 U; 08.07.1988 DE 8808815 U
(43) Veröffentlichungstag der Anmeldung: 27.12.1989
(73) Patentinhaber: Heimann Optoelectronics GmbH, D-65199 Wiesbaden (DE)
(72) Erfinder: Quad, Reiner, Dr., D-6204 Taunusstein (DE); Ringelstein, Udo, D-6223 Lorch (DE); Plotz, Fred, D-6200 Wiesbaden (DE); Knaup, Gerhard, D-6143 Lorsch (DE)
(74) Vertreter: Beetz & Partner Patentanwälte

(56) Entgegenhaltungen:
- DE-A- 2 916 744
- DE-A- 2 950 649
- GB-A- 2 107 929
- US-A- 4 047 045
- US-A- 4 198 564
- PATENT ABSTRACTS OF JAPAN, Band 7, Nr. 76 (E-167)[1221], 30. März 1983, Seite 72 E 167; & JP-A-58 4953

## Beschreibung

Die Erfindung betrifft einen infrarotdetektor mit mindestens einem Detektorelement, das in einem Gehäuse gehaltert ist, welches ein für Infrarotstrahlung durchlässiges Fenster über dem Detektorelement aufweist, und mit weiteren elektrischen Bauelementen, die mit dem Detektorelement zusammengeschaltet sind.

Infrarotdetektoren dieser Art mit pyroelektrischen Detektorelementen finden ihre Hauptanwendung in Einbruchalarmgeräten und automatischen Lichtschaltern Ausgenutzt wird die in der Regel von der Umgebung unterschiedliche Temperatur des menschlichen Körpers Bewegt sich ein Mensch im Erfassungsbereich eines infrarotdetektors, so ändert sich die auf dem Detektorelement auftreffende Strahlungsleistung und damit die Temperatur des Detektorelementes. Aufgrund des pyroelektrischen Effektes ändert sich dabei die spontane Polarisation des Materials, was zu einer Ladungserzeugung führt. Diese Ladung wird auf Elektroden abgezogen und mittels eines Impedanzwandlers in eine Spannung umgeformt. Als Impedanzwandler dient ein Feldeffekttransistor mit geringem Gate-Leck-Strom.

Die bisher verfügbaren Infrarotdetektoren für die beschriebene Anwendung verwenden ein für Infrarotstrahlung durchlässiges Fenster, das in eine metallische Gehäusekappe eingeklebt wird. Auf einer Montageplatte werden die Bauelemente montiert und die beiden Gehäuseteile dicht miteinander verbunden.

Die bekannten Ausführungen von Infrarotdetektoren haben alle den Nachteil, daß eine automatische Prüfung und Positionierung auf einer Leiterplatte nur in sehr eingeschränktem Umfang oder mit aufwendigen Spezialgeräten möglich ist.

Ein Infrarotdetektor, in dem ein Detektorelement auf einem aus isolierendem Material bestehenden substrat befestigt ist, ist aus DE-A-2916744 bekannt.

Der Erfindung liegt die Aufgabe zugrunde, einen Infrarotdetektor der eingangs genannten Art so auszubilden, daß er bei mindestens gleichen optoelektrischen Daten wie bekannte Ausführungen sich durch einfache Montage, höhere Zuverlässigkeit und vereinfachte Weiterverarbeitung auszeichnet.

Diese Aufgabe ist erfindungsgemäß dadurch gelöst, daß das Gehäuse von einem Kunststoff-Formteil gebildet ist, in dem ein Formblech sowie das Detektorelement und die Bauelemente eingebettet sind, wobei das Formblech zur elektrischen Verbindung des Detektorelements und der Bauelemente dient und mit vom Formteil nach außen ragenden Ansätzen zum elektrischen Anschluß versehen ist, und daß im Formteil Stufen zur Aufnahme des Detektorelementes und eines Infrarotfilters angeordnet sind. Bei dem erfindungsgemäßen Infrarotdetektor ist aufgrund der aus dem Formteil herausragenden Anschlußkontakte eine definierte optische Ausrichtung ohne zusätzliche Justierhilfsmittel gewährleistet. Es kann auf gebräuchliche Montageeinrichtungen zurückgegriffen werden.

Als pyroelektrisches Material für das Detektorelement wird ein dünnes Plättchen einer Keramik oder eines Kristalles verwendet. Auf der Oberfläche dieses Plättchens sind Elektroden aufgebracht, die zwei getrennte Kondensatoren bilden. Diese sind entweder seriell oder entgegengesetzt parallel verschaltet. Dabei ist für den erfindungsgemäßen Aufbau die serielle Verschaltung empfehlenswert. Bei dieser seriellen Verschaltung sind die Elektroden auf der der Strahlung zugewandten Seite verbunden und eventuell zusätzlich mit einer Infrarotstrahlung absorbierenden Schicht versehen.

Wie bei in Kunststoff gekapselten elektrischen Bauelementen üb lich, wird beim Aufbau des Infrarotdetektors von einer Kontaktspinne ausgegangen. Diese beinhaltet die Montage- und Kontaktflächen für die Bauteile und enthält die Anschlußkontakte des späteren Infrarotdetektors. Diese Anschlußkontakte sind mit Haltestegen verbunden, um eine Abarbeitung von einer Endlosrolle zu ermöglichen. Wegen der hohen Impedanz der Detektorelemente ist es notwendig, eine möglichst vollständige leitfähige Umschließung dieser Detektorelemente und auch des Feldeffekttransistors (FET) zu erreichen. Daher wurden bisher fast ausschließlich Metallgehäuse verwendet. Teile des Formbleches sind bei der vorliegenden Erfindung nach oben gebogen und bilden damit zusammen mit der Grundfläche einen Teil des Abschirmkäfigs. Ein aus Abschirmmaterial bestehendes Gehäuse kann demgemäß entfallen. Als Impedanzwandler kann ein gekapselter FET verwendet werden.

Die Anschlüsse des Formbleches für Source-, Drain- und Masseverbindung zum FET sind in verschiedene Ebenen gebogen und so geformt, daß sie zusammen mit dem Formblech eine Tasche bilden, in der der FET positioniert werden kann. Dies ermöglicht eine einfache Montage.

Beim Einspritzen mit Duro- oder Thermoplasten wird eine Öffnung im Gehäuse belassen, durch die das gegen hohe Temperaturen empfindliche Sensorelement nachträglich montiert wird. Dabei sind Auflage- und Positionierflächen am Formblech und an der Umspritzung, also am Formteil, ausgebildet. Zusätzlich enthält das Formteil um seine Öffnung herum einen Aufnahmerand, in den das Infrarotfenster in Form eines Fensters eingeklebt wird.

Das Formblech ist weiterhin so geformt, daß hochstehende Flächen beim Einkleben des Infrarotfilters mit diesem leitfähig verbunden werden und damit den Abschirmkäfig schließen.

Durch den beschriebenen Aufbau wird eine automatische Montage auf Fertigungsanlagen ermöglicht, wie sie sich in der Halbleiter-Chipkonfektionierung schon lange bewährt hat.

In der gleichen Bauform ist es durch Hinzunahme von weiteren Anschlüssen und damit Verlängern des Gehäuses möglich, die für die Anwendung des Infrarotdetektors in einem Alarmgerät oder in einem automatischen Lichtschalter notwendigen Schaltelemente zu integrieren.

Die Erfindung ist nachfolgend anhand von in der Zeichnung dargestellten Ausführungsbeispielen näher erläutert. Es zeigen:
- Fig. 1: eine Kontaktspinne zur Erläuterung der Fertigung des erfindungsgemäßen Infrarotdetektors,
- Fig. 2 und 3: zwei zueinander senkrecht liegende Schnitte durch einen Infrarotdetektor nach der Erfindung,
- Fig. 4 und 5: eine Aufsicht von innen und von außen des Infrarotdetektors gemäß den Fig. 2 und 3,
- Fig. 6: einen Schnitt durch eine Variante des Infrarotdetektors gemäß den Fig. 2 bis 5,
- Fig. 7: das Schaltbild des Infrarotdetektors gemäß den Fig. 1 bis 6, und
- Fig. 8: eine weitere Variante eines Infrarotdetektors nach der Erfindung im Schnitt.

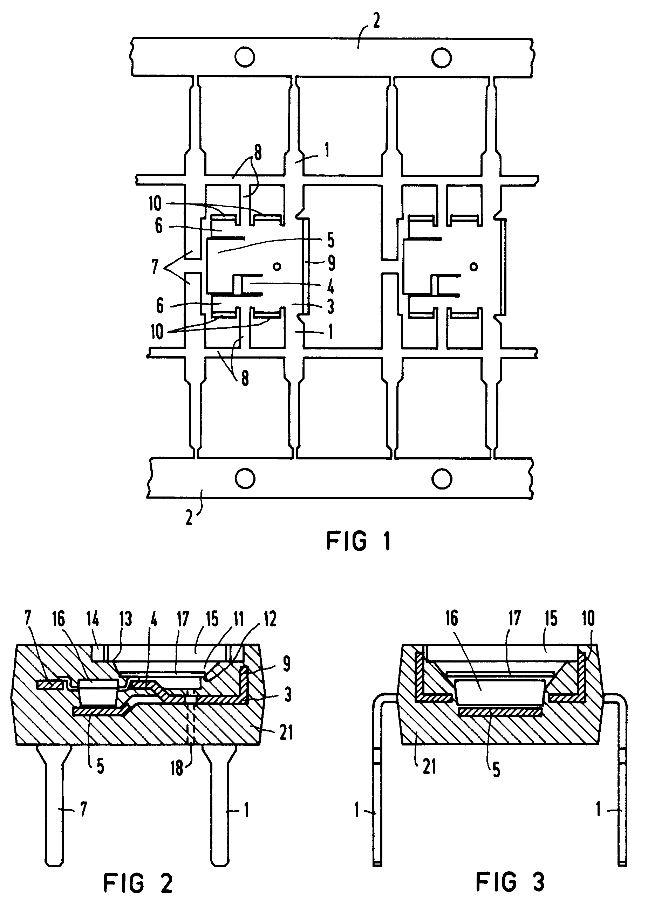

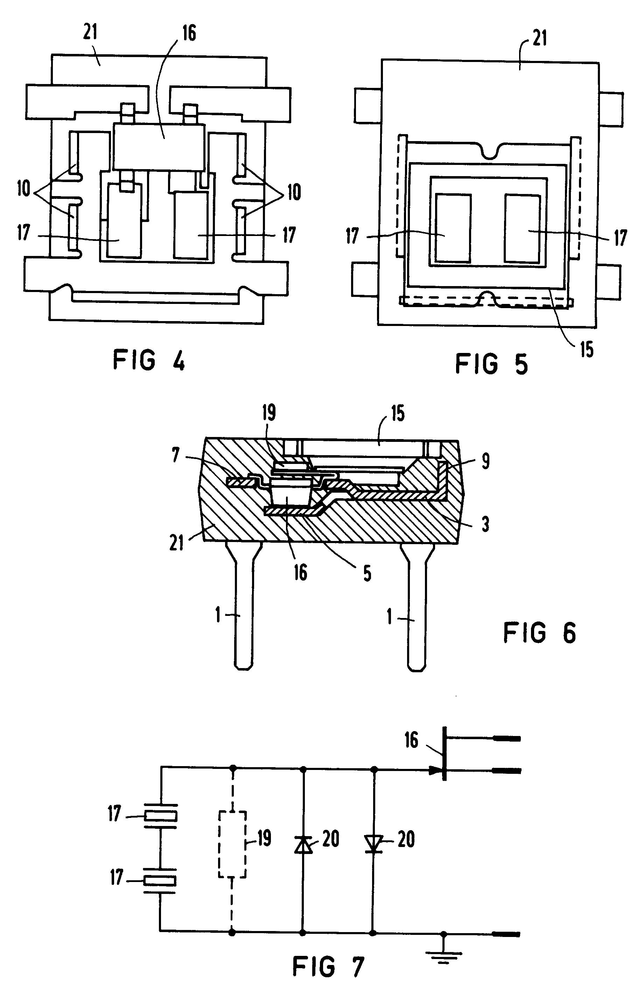

Der in den Fig. 2 bis 6 dargestellte Infrarotdetektor weist gemäß Fig. 7 zwei Detektorelemente 17, gegebenenfalls einen Ableitwiderstand 19, der durch zwei antiparallele Dioden 20 mit Leckströmen im Bereich von pA ergänzt wird und einen FET 16 auf.

In den Fig. 2 bis 6 ist ein Infrarotdetektor mit den genannten Bauteilen in einem kunstoffgespritzten Gehäuse mit vier Anschlußkontakten, wovon zwei die Anschlußkontakte "Source" und "Drain" des FET's bilden und die beiden weiteren den Massekontakt liefern, beschrieben.

Der Aufbau des Infrarotdetektors geht von einer Kontaktspinne nach Fig. 1 aus. Die Massekontakte 1, die nach beiden Seiten mit einem Halte- und Positionierstreifen 2 verbunden sind, halten und kontaktieren ein Formblech 3 der gleichen Kontaktspinne. Aus diesem Formblech 3 ist nach oben ein Blechstreifen 4 herausgebogen, der zur Kontaktierung und Stützung des Masseanschlusses des FET's 16 dient. Zusätzlich ist ein weiteres Blech 5 heruntergebogen, das unter dem FET 16 für eine Abschirmung sorgt. Die Breite dieses Formbleches 3 ist so bemessen, daß sich auf beiden Seiten zwei Positionierstege 6 für den FET 16 ergeben.

Zum Anschluß von "Source" und "Drain" dienen zwei auf die Höhe der Massekontakte 1 gebogene Bleche 7.

Zur Versteifung während der Montage dienen Haltestege 8, die nach dem Umspritzen abgetrennt werden. Weiterhin sind auf drei Seiten Bleche 9, 10 senkrecht hochgebogen, die die seitliche Abschirmung bilden. Die Bleche 10 schaffen auch die Verbindung zum Infrarotfilter 15, der den Abschirmkäfig schließt.

Der gekapselte FET 16 mit integrierten Dioden 20 wird von der in der Kontaktspinne gebildeten Tasche positioniert. Der Source-, Drain- und Masseanschluß wird zur Kontaktierung durch Verschweißen oder Verlöten mit den Blechstreifen 4 bzw. Blechen 7 verbunden. Der Gateanschluß des FET 16 hängt dabei frei und dient zur späteren Kontaktierung des oberen Detektorelementes 17 (Fig. 7).

Nach der Montage des FET's 16 kann der Aufbau gemäß Fig. 2 bis im Vielfachwerkzeug mit Duro- oder Thermoplasten umspritzt werden. Dabei wird im Gehäuse eine Öffnung 11 geschaffen, in der der Masse- und Gatekontakt des FET 16 offen liegen (siehe Fig. 2). Diese Öffnung enthält in Höhe der FET-Kontakte eine Stufe 12, die zur Aufnahme der Detektorelemente 17 dient. Die Wandung ist nach unten hin schräg zulaufend ausgeführt, so daß die Detektorelemente 17 nach Einbringen automatisch positioniert werden. Der Kontakt zu dem Masse- und Gateanschluß des FET's 16 wird entweder gelötet oder leitfähig verklebt. Zusätzlich kann auf den Masse- und Gateanschlußkontakt des FET's 16 der Widerstand 19 mit Anschlußflächen nach unten kontaktiert werden (siehe Fig. 6). Dieser als Gateableitwiderstand wirkende Widerstand 19 ist auf einem Aluminiumoxydsubstrat aufgebracht. Der Widerstand 19 wird wie in Fig. 6 gezeigt über dem FET 16 oder auf dem Boden der Gehäuseöffnung montiert und in diesem Fall mit Anschlußkontakten nach oben mit dem Masse- und Gateanschluß des FET's 16 verbunden.

Die Gehäuseöffnung enthält am oberen Rand eine weitere umlaufende Stufe 13, die zur Aufnahme des Infrarotfilters 15 dient. Dabei sind auf den Längsseiten Freiräume 14 geschaffen, die ein Reservoir für den leitfähigen Kleber beim Verschließen des Gehäuses bilden. In diese Stufe ragen die Bleche 10 des Formbleches 3 hinein (siehe Fig. 3 und 4).

Zur Entgasung beim Aushärten des Klebers dient eine kleine Öffnung 18 auf der Gehäuseunterseite, die anschließend verschlossen wird.

Nach Abdichten des vorher mit Stickstoff gefluteten Gehäuses werden die Haltestege 8 abgestanzt. Die Anschlußbeinchen (Massekontakte 1, Bleche 7) werden von den Halte- und Positionierstreifen 2 getrennt und um 90° nach unten gebogen.

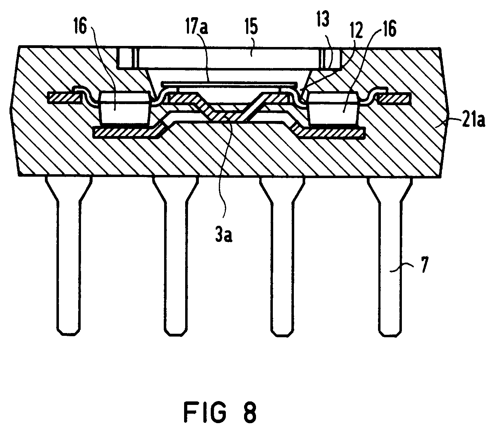

Die Fig. 8 zeigt die Ausführung eines 4-Element-Detektors mit zwei FET's 16 in gleicher Fertigungstechnik. Dabei sind zwei unabhängig arbeitende Dual-Element-Detektorelemente 17a enthalten. Bei der Montage wird von einem entsprechend geänderten Formblech 3a ausgegangen.

Gemeinsam ist den in den Fig. 2 bis 6, 8 gezeigten Ausführungsbeispielen, daß das Gehäuse von einem Kunststoff-Formteil 21, 21a gebildet ist, in dem ein Formblech 3, 3a sowie die Bauelemente 16, 17, 17a gegebenenfalls 19 und 20 eingebettet sind, wobei das Formblech 3, 3a die Bauelemente 16, 17, 17a gegebenenfalls 19 und 20 elektrisch verbindet und mit nach außen ragenden Ansätzen, nämlich den Massekontakten 1 und den Blechen 7, zum elektrischen Anschluß des Infrarotdetektors versehen ist. Im Formteil 21, 21a sind die insbesondere in den Fig. 2, 3, 6, 8 sichtbaren Stufen 12, 13 zur Aufnahme der Detektorelemente 17, 17a und des Infrarotfilters 15 angeordnet. Die abgebogenen Bereiche, nämlich der Blechstreifen 4, das Blech 5 und die Bleche 9, 10 decken die Bauelemente 16, 17, 17a gegebenenfalls 19 und 20 zur Abschirmung ab.

## Patentansprüche

1. Infrarotdetektor mit mindestens einem Detektorelement (17, 17a), das in einem Gehäuse gehaltert ist, welches ein für Infrarotstrahlung durchlässiges Fenster über dem Detektorelement (17, 17a) aufweist, und mit weiteren elektrischen Bauelementen (16, 19, 20), die mit dem Detektorelement (17, 17a) zusammengeschaltet sind, **dadurch gekennzeichnet,** daß das Gehäuse von einem Kunststoff-Formteil (21, 21a) gebildet ist, in dem ein Formblech (3, 3a) sowie das Detektorelement (17, 17a) und die Bauelemente (16, 19, 20) eingebettet sind, wobei das Formblech (3, 3a) zur elektrischen Verbindung des Detektorelements (17, 17a) und der Bauelemente (16, 19, 20) dient und mit vom Formteil (21, 21a) nach außen ragenden Ansätzen (1, 7) zum elektrischen Anschluß versehen ist, und daß im Formteil (21, 21a) Stufen (12, 13) zur Aufnahme des Detektorelementes (17, 17a) und eines Infrarotfilters (15) angeordnet sind.

2. Infrarotdetektor nach Anspruch 1, **dadurch gekennzeichnet,** daß das Formblech (3, 3a) abgebogene Bereiche (5, 9, 10) aufweist, welche mindestens einen Teil der Bauelemente (16, 19, 20) und das Detektorelement (17, 17a) zur Abschirmung mindestens teilweise abdecken.

## Claims

1. An infrared detector comprising at least one detector element (17, 17a) mounted in a housing having a window permeable to infrared radiation above the detector element (17, 17a), and comprising other electrical components (16, 19, 20) connected to the detector element (17, 17a), characterised in that the housing is a plastic moulding (21, 21a) in which a shaped metal plate (3, 3a), and the detector element (17, 17a) and the components (16, 19, 20) are embedded, the shaped plate (3, 3a) serving for electrical connection of the detector element (17, 17a) and the components (16, 19, 20), and being provided with electrical connection tags (1, 7) projecting outwardly from the moulding (21, 21a), and in that the moulding (21, 21a) contains steps (12, 13) to receive the detector elements (17, 17a) and an infrared filter (15).

2. An infrared detector according to claim 1, characterised in that the shaped metal plate (3, 3a) has bent-off zones (5, 9, 10) which for screening purposes at least partially cover at least a part of the components (16, 19, 20) and the detector element (17, 17a).

## Revendications

1. Détecteur infrarouge comportant au moins un élément détecteur (17, 17a) qui est fixé dans un boîtier comportant au-dessus de l'élément détecteur (17, 17a) une fenêtre perméable au rayonnement infrarouge, et d'autres éléments de construction électriques (16, 19, 20) qui sont branchés avec l'élément détecteur (17, 17a), caractérisé en ce que le boîtier est formé par une pièce façonnée en matière plastique (21, 21a) dans laquelle sont insérés une tôle profilée (3, 3a) ainsi que l'élément détecteur (17, 17a) et les éléments de construction (16, 19, 20), la tôle profilée (3, 3a) servant à la connexion électrique de l'élément détecteur (17, 17a) et des éléments de construction (16, 19, 20) et étant munie de protubérances (1, 7) qui font saillie de la pièce façonnée (21, 21a) vers l'extérieur et qui sont destinées au raccordement électrique, et en ce que des gradins (12, 13) destinés à recevoir l'élément détecteur (17, 17a) et un filtre infrarouge (15) sont prévus dans la pièce façonnée (21, 21a).

2. Détecteur infrarouge selon la revendication 1, caractérisé en ce que la tôle profilée (3, 3a) présente des domaines recourbés (5, 9, 10) qui recouvrent au moins partiellement une partie au moins des éléments de construction (16, 19, 20) et l'élément détecteur (17, 17a) en vue du blindage.
